# EUROPEAN PATENT SPECIFICATION

(11) **EP 4 020 561 B1**
(45) Date of publication and mention of the grant of the patent: **30.07.2025**
(21) Application number: 21195965.5
(22) Date of filing: 10.09.2021
(51) Int. Cl.: H10B 53/20, H10B 53/30, H10D 1/68, G11C 11/22, G11C 11/56

(54) **METAL REPLACEMENT PLATE LINE PROCESS FOR 3D-FERROELECTRIC RANDOM (3D-FRAM)**
LINIENVERFAHREN FÜR METALLISCHE ERSATZPLATTEN FÜR 3D-FERROELEKTRISCHE DIREKTZUGRIFFSPEICHER (3D-FRAM)
PROCESSUS DE LIGNE DE PLAQUE DE REMPLACEMENT MÉTALLIQUE POUR MÉMOIRE VIVE FERROÉLECTRIQUE 3D (3D-FRAM)

(30) Priority: 26.12.2020 US 202017134279
(43) Date of publication of application: 29.06.2022
(73) Proprietor: INTEL Corporation, Santa Clara, CA 95054 (US)
(72) Inventor: HARATIPOUR, Nazila, Portland, OR 97204 (US); Chang, Sou-Chi, Portland, OR 97229 (US); Shivaraman, Shriram, Hillsboro, OR 97124 (US); AVCI, Uygar E., Portland, OR 97225 (US); KAVALIEROS, Jack, Portland, OR 97229 (US)
(74) Representative: Goddar, Heinz J.

(56) References cited:
- US-A1- 2016 079 259
- US-A1- 2019 221 609
- US-A1- 2020 051 607
- US-A1- 2020 227 439
- CHANG SOU-CHI ET AL: "Anti-ferroelectric HfxZr1-xO2 Capacitors for High-density 3-D Embedded-DRAM", 2020 IEEE INTERNATIONAL ELECTRON DEVICES MEETING (IEDM), IEEE, 12 December 2020 (2020-12-12), XP033886058, DOI: 10.1109/IEDM13553.2020.9372011

## Description

### TECHNICAL FIELD

Embodiments of the disclosure are in the field of integrated circuit structures and, in particular, a metal replacement plate line process for 3D-Ferroelectric Random (3D-FRAM).

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and state-of-the-art fabrication processes may limit the possibility to further extend them into the sub-10 nm range. Consequently, fabrication of the functional components needed for future technology nodes may require the introduction of new methodologies or the integration of new technologies in current fabrication processes or in place of current fabrication processes.

Devices and methods of the prior art are described by US 2020 / 0051607 A; Sou-Chi Chang et al., "Anti-ferroelectric HfxZr1-xO2 Capacitors for High-density 3-D Embedded-DRAM", 2020 IEEE International Devices Meeting (IEDM), doi:10.1109/IEDEM13553.2020.9372011, (2020); US 2020 / 0227439 A1, US 2019 / 0221609 A1, US 2016 / 0079259 A1. None of these describe a combination of adhesion layers and voids in the plate lines or undercut etching as defined by the independent claims.

The invention is set forth in the independent claims including a memory device comprising the features of claim 1 and a method for fabricating a memory device comprising the features of claim 13. Embodiments of the invention are described in the dependent claims.

According to an embodiment the method of fabricating a memory device comprises forming an access transistor at the base level of the memory device. A stack of alternating dummy nitride material and an insulating material is blanket deposited over a substrate and in an isolation region. A node is formed over the access transistor for at least two ferroelectric capacitors, the node formed through the stack of alternating dummy nitride material and the insulating material. A staircase etch is performed on the stack of alternating dummy nitride material in the insulator material. The dummy nitride material is removed during a dummy replacement process by performing an undercut etch on the dummy nitride material selective to the insulating material, which leaves rows of the insulating material and empty spaces therebetween. An adhesion layer is deposited along a top and bottom services of the rows of the insulating material and depositing a conformal metal material on top of the stack and in between the rows of insulating material to begin formation of plate lines. A spacer anisotropic etch is performed to remove excess metal material from the top and sidewalls of the insulating material so that sidewalls of the plate lines are vertically aligned with sidewalls of the insulating material. An interlayer dielectric (ILD) is formed over the isolation region and defining contact and via locations. An etch of the ILD is performed over the contact and Via locations that stops on the metal material to form vias through the ILD and the isolation region that land on each of the plate lines to form separate capacitors that have a common node at the center.

According to an embodiment the method further comprises depositing the dummy nitride material as silicon nitride, aluminum oxide, silicon oxide nitride, or any combination thereof.

According to an embodiment the method further comprises depositing the insulating material as oxide, silicon oxide, silicon dioxide, a carbon doped oxide, or any combination thereof.

According to an embodiment the method further comprises depositing the metal material as titanium, titanium nitride, tantalum nitride, platinum, copper, tungsten, tungsten nitride, ruthenium, molybdenum or any combination thereof.

According to an embodiment the method further comprises that forming the node further comprises: etching a hole through the stack of alternating dummy nitride material and the insulating material down to a source or drain of the access transistor; and depositing a ferroelectric or antiferroelectric material conformal to sidewalls of the holes.

According to an embodiment the method further comprises depositing the ferroelectric material as any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

According to an embodiment the method further comprises depositing the metal material using atomic layer deposition.

According to an embodiment the method further comprises depositing the metal material such that voids are formed in the metal material.

According to an embodiment the method further comprises fabricating the memory device as a 3D FRAM.

According to an embodiment the method further comprises that forming the access transistor further comprises patterning a plurality of substantially parallel bitlines along a first direction within an insulating material over a substrate and forming a plurality of substantially parallel wordlines along a second direction orthogonal to the direction of the bitlines, and forming the access transistor at the intersection of the one of the bitlines and one of the wordlines.

### BRIEF DESCRIPTION OF THE DRAWINGS

Figure 1 illustrates a cross-section of a 3D FRAM memory.
Figure 2 illustrates a cross-section of a 3D FRAM memory according to the disclosed embodiments.
Figures 3A-3F illustrate cross-sectional views showing a process for fabricating a 3D FRAM in further detail, where like reference numerals from Figure 2 have like reference numerals.
Figures 4A and 4B illustrate a wafer composed of semiconductor material and includes one or more dies having integrated circuit (IC) structures formed on a surface of the wafer.
Figure 5 illustrates a block diagram of an electronic system, in accordance with an embodiment of the present disclosure.
Figure 6 is a cross-sectional side view of an integrated circuit (IC) device assembly that may include one or more ferroelectric trench capacitors, in accordance with one or more of the embodiments disclosed herein.
Figure 7 illustrates a computing device in accordance with one implementation of the disclosure.

### DESCRIPTION OF THE EMBODIMENTS

A metal replacement plate line process for 3D-Ferroelectric Random (3D-FRAM) is described. In the following description, numerous specific details are set forth, such as specific material and tooling regimes, in order to provide a thorough understanding of embodiments of the present disclosure. It will be apparent to one skilled in the art that embodiments of the present disclosure may be practiced without these specific details. In other instances, well-known features, such as single or dual damascene processing, are not described in detail in order to not unnecessarily obscure embodiments of the present disclosure. Furthermore, it is to be understood that the various embodiments shown in the Figures are illustrative representations and are not necessarily drawn to scale. In some cases, various operations will be described as multiple discrete operations, in turn, in a manner that is most helpful in understanding the present disclosure, however, the order of description should not be construed to imply that these operations are necessarily order dependent. In particular, these operations need not be performed in the order of presentation.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Embodiments described herein may be directed to front-end-of-line (FEOL) semiconductor processing and structures. FEOL is the first portion of integrated circuit (IC) fabrication where the individual devices (e.g., transistors, capacitors, resistors, etc.) are patterned in the semiconductor substrate or layer. FEOL generally covers everything up to (but not including) the deposition of metal interconnect layers. Following the last FEOL operation, the result is typically a wafer with isolated transistors (e.g., without any wires).

Embodiments described herein may be directed to back end of line (BEOL) semiconductor processing and structures. BEOL is the second portion of IC fabrication where the individual devices (e.g., transistors, capacitors, resistors, etc.) are interconnected with wiring on the wafer, e.g., the metallization layer or layers. BEOL includes contacts, insulating layers (dielectrics), metal levels, and bonding sites for chip-to-package connections. In the BEOL part of the fabrication stage contacts (pads), interconnect wires, vias and dielectric structures are formed. For modern IC processes, more than 10 metal layers may be added in the BEOL.

Embodiments described below may be applicable to FEOL processing and structures, BEOL processing and structures, or both FEOL and BEOL processing and structures. In particular, although an exemplary processing scheme may be illustrated using a FEOL processing scenario, such approaches may also be applicable to BEOL processing. Likewise, although an exemplary processing scheme may be illustrated using a BEOL processing scenario, such approaches may also be applicable to FEOL processing.

One or more embodiments may be implemented to realize a metal replacement plate line process for 3D-Ferroelectric Random (3D-FRAM). To provide context, a FRAM is a random-access memory similar in construction to DRAM but uses a ferroelectric layer instead of a dielectric layer to achieve non-volatility. Conventionally, both FRAM and DRAM are one transistor (1T)/one capacitor (1C) cell arrays, where each cell comprises an access transistor in the front end coupled to a single capacitor. The capacitor may be coupled to a bitline (COB) higher in the stack in the semiconductor back end.

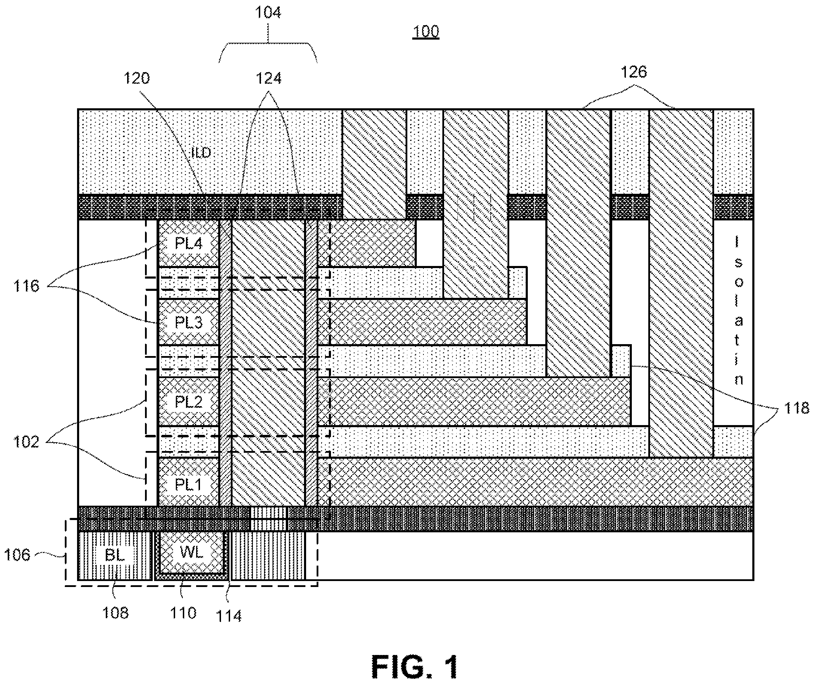

Figure 1 illustrates a cross-section of a 3D FRAM memory. The 3D FRAM memory 100 comprises a 3D array of ferroelectric capacitors 102 arranged in one or more vertical stacks 104 or columns, each of the ferroelectric capacitors 102 in the stack is coupled to a single access transistor 106 at the base of the stack. The 3D FRAM memory 100 includes a base level having a plurality of substantially parallel bitlines 108 along a first direction. On a base +1 level, the 3D array comprises a plurality of substantially parallel wordlines 110 along a second direction, typically orthogonal to the first direction. The access transistor 106 is located at the intersection of a respective bitline 108 and a respective wordline 110 and is coupled to the respective bitline 108 and wordline 110. A gate dielectric 114 may be along sides of the wordline 110 beneath each stack 104.

Each stack 104 in the 3D array comprises a first ferroelectric capacitor 102 vertically aligned with and coupled to the access transistor 106 and at least a second ferroelectric capacitor 102 vertically aligned with the first ferroelectric capacitor 102 and also coupled to the access transistor 106, wherein both the first ferroelectric capacitor 102 and the second ferroelectric capacitor 102 are controlled by the access transistor 106. In the example shown, the stack comprises four vertically stacked ferroelectric capacitors 102. In one embodiment, the access transistor 106 may be coupled to 2-8 ferroelectric capacitors 102.

Over the access transistor 106 is a stack of alternating plate lines 116 (e.g., PL1, PL2, PL3, PL4) and an insulating material 118 (e.g., an interlayer dielectric (ILD)) that may be substantially parallel to the bitlines 108. In one embodiment, the number of plate lines 116 equals the number of ferroelectric capacitors 102 in the stack 104. Accordingly, in the example shown, there are four ferroelectric capacitors 102, and four plate lines 116 separated by four layers of insulating material 118. Vias 126 or pillars are connected to edges of the plate lines 116.

In one embodiment, a node 120 of each of the ferroelectric capacitors 102 is formed and located in a hole through the stack of alternating plate lines 116 and the insulating material 118 in alignment with the access transistor 106. The node 120 is one of the terminals of each of the ferroelectric capacitors 102 and is connected to, or comprises, a drain of the access transistor 106. Thus, the node 120 and the drain of the access transistor 106 are basically the same electrical point. The node 120 is surrounded by a ferroelectric (or antiferroelectric) material 124 that is conformal to sidewalls of the hole. The ferroelectric material 124 stores the memory state for a bit cell as a form of polarization, which can be switched by an electric field. The node 120 is further connected to one plate line 116 of each of the ferroelectric capacitors 102 in the stack 104. Each of the plate lines 116 acts as a first electrode and the node 120 acts as a second electrode for the corresponding ferroelectric capacitor 102 in the stack 104.

One advantage of the 3D FRAM memory 100 is that it enables cell scaling due to immunity to leakage and data is stored in the form of polarization in the capacitor. This type of storage allows the capacitors to be stacked to further scale the cell and achieve X Bit/Area monolithic integration where X is the number of stacked capacitors.

However, the 3D FRAM memory 100 is fabricated by a blanket depositing an alternating stack of metal plate lines 116 and the insulating material 118. One problem with this process is the stack of thick metal layers cannot be seen through for lithography purposes so that in subsequent processing steps an additional frame reveal mask is required to create openings through the alternating stack of metal plate lines 116 and the insulating material 118 to reveal the alignment marks on the first level of the wafer. Alignment marks are typically formed on the first level to provide means for registering the photomask for the subsequent photolithography step. The additional frame reveal mask requires an additional lithography step and a high aspect ratio metal etch, which adds costs.

One or more embodiments described herein are directed to structures and architectures for fabricating a 3D-FRAM using a metal replacement plate line fabrication process. Rather than starting the fabrication process by depositing an alternating stack of metal plate lines and the insulating material, one or more embodiments is directed to starting the fabrication process by depositing an alternating stack of dielectric materials, such as silicon nitride and silicon oxide, so that lithography can be used to see through the stack to find the alignment marks, eliminating the need for the additional frame reveal mask and corresponding lithography step. Thereafter, the silicon nitride is removed and replaced with a metal to form the plate lines. In other words, the fabrication process replaces initial use of a metal with a dummy nitride layer, removes the dummy nitride layer in subsequent 3D FRAM processing steps, and replaces the dummy nitride layer with a low resistance metal to complete the processing.

As a result of the fabrication process, a 3D FRAM memory device is formed having an access transistor comprising a bitline and a wordline. A series of alternating plate lines and an insulating material is over the access transistor, the plate lines comprising an adhesion material on a top and a bottom thereof and a metal material in between the adhesion material, the metal material having one or more voids therein. (The presence of the voids in the metal material as a result of the dummy nitride replacement process that conformally deposits the metal into horizontal areas between the insulating materials after removal of the dummy nitride.) Two or more ferroelectric capacitors is over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor. A plurality of vias each land on a respective one of the plate lines.

A 3D-FRAM is fabricated with a dummy nitride process that eliminates the need for an additional frame reveal mask and corresponding lithographic process. It also allows using metals with low resistivity to reduce plateline resistance. The 3D-FRAM having multiple bits per access transistor and a high bit-density of 5-10 times greater than traditional FRAM and DRAM memories with low cost and area per bit. Embodiments may include or pertain to one or more of memory, ferroelectric memory, 3D ferroelectric memory and system-on-chip (SoC) technologies.

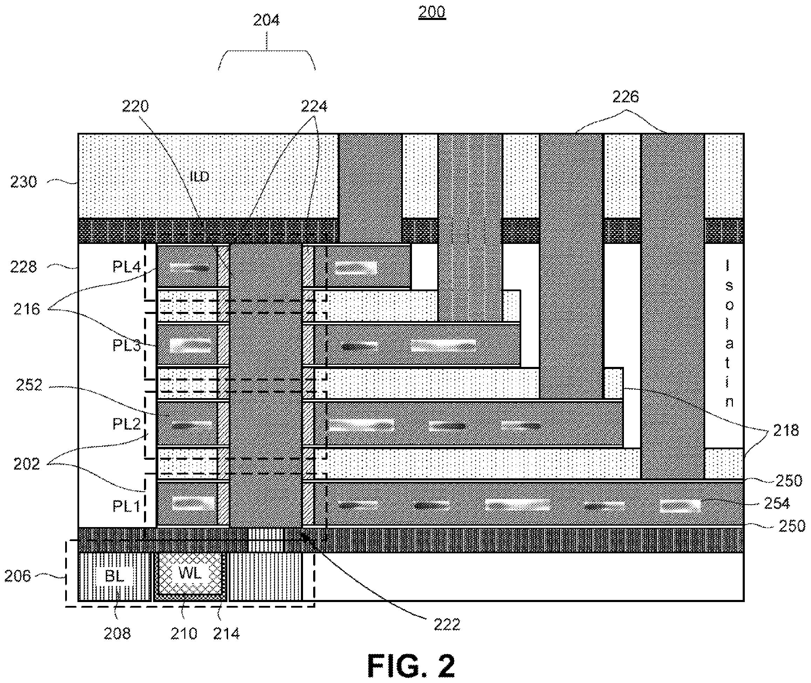

Figure 2 illustrates a cross-section of a 3D FRAM memory according to the invention. The 3D FRAM memory 200 is similar to the 3D FRAM memory 100 but has a different fabrication process. The 3D FRAM memory 200 includes a base level having a plurality of substantially parallel (e.g., within +-5 degrees) bitlines 208 along a first direction and a plurality of substantially parallel wordlines 110 along a second direction orthogonal (e.g., within +-5 degrees) to the first direction (e.g., in and out of the page in this view). The base level further comprises a plurality of access transistors 206, where each respective access transistor 206 comprises a respective bitline 208 and a respective wordline 210. The wordline 210 comprises a channel region of the access transistor 206 and a gate dielectric 214 is along sides of the wordline 210. In one embodiment, the channel region has substantially a same lateral dimension as the wordline 210, and the gate length may be measured in the vertical direction. The access transistor 206 may comprise any type of transistor, such as a planar transistor, a thin film transistor, a fin field effect transistor (FinFET), a 2D channel transistor, a polysilicon transistor or any layered transfer transistor, for example.

Over each access transistor 206 is an isolation region 228 having a series of alternating plate lines 216 (e.g., PL1, PL2, PL3, PL4) and an insulating material 218 (e.g., an interlayer dielectric (ILD)) formed therein. The plate lines 216 each comprise an adhesion material 250 on a top and a bottom thereof and a metal material 252 in between the adhesion material 250, where the metal material 252 has one or more voids 254 formed therein. The voids 254 are a result of a dummy nitride replacement process of the disclosed embodiments that is used to fabricate the 3D FRAM memory 200, as explained further below.

The alternating plate lines 216 and an insulating material 218 may be substantially parallel to the bitlines 208 in one embodiment. The 3D FRAM memory 200 further comprises a 3D array of two or more stacks of ferroelectric capacitors 202 that are formed over the access transistor 206 and through the series of alternating plate lines 216 and the insulating material 218, such that a first one of the ferroelectric capacitors is coupled to a first one of the plate lines and a second one of the ferroelectric capacitors is coupled to a second one of the plate lines, and where the two or more ferroelectric capacitors are each coupled to and controlled by the access transistor 206. A plurality of vias 226 is formed through an interlayer dielectric (ILD) 230 and the isolation region 228 so that each via 226 lands on a respective one of the plate lines 216. In one embodiment, the plurality of vias 226 comprise the same metal material 252 as the plate lines 216.

The ferroelectric capacitors 202 are arranged in a vertical stack 204 or column, where the stack 204 of ferroelectric capacitors 202 is coupled to the access transistor 206 at the base of the stack 204. Each stack 204 in the 3D array comprises a first ferroelectric capacitor 202 vertically aligned with and coupled to the access transistor 206 and at least a second ferroelectric capacitor 202 vertically aligned with the first of ferroelectric capacitor 202 and also coupled to the access transistor 206, wherein both the first ferroelectric capacitor 202 and the second ferroelectric capacitor 202 are controlled by the access transistor 206. In the example shown, each stack 204 in the 3D array comprises four vertically stacked ferroelectric capacitors 202. In one embodiment, each access transistor 206 may be coupled to 2-8 ferroelectric capacitors 202.

In one embodiment, the number of plate lines 216 equals the number of ferroelectric capacitors 202 in the stack 204. Accordingly, in the example shown, there are four ferroelectric capacitors 202, and four plate lines 216 separated by four layers of insulating material 218. In one embodiment, a node 220 of each of the capacitors 206 is formed and located in a hole 222 through the stack of alternating plate lines 216 and the insulating material 218 in alignment with the corresponding channel region and the access transistor 206.

The node 220 is one of the terminals of each of the ferroelectric capacitors 202 and is connected to, or comprises, a drain of the access transistor 206. Thus, the node 220 and the drain of the access transistor 206 are basically the same electrical point. The node 220 is surrounded by a ferroelectric (or antiferroelectric) material 224 that is conformal to sidewalls of the hole 222. The ferroelectric material 224 stores the memory state for a bit cell as a form of polarization, which can be switched by an electric field. The node 220 is further connected to one plate line 216 of each of the ferroelectric capacitors 202 in the stack 204. Each of the plate lines 216 acts as a first electrode and the node 220 acts as a second electrode for the corresponding ferroelectric capacitor 202 in the stack 204. In this embodiment, the bitline 208 may be the source of the access transistor 206.

As described previously, the number of plate lines 216 may range from 2-8 using existing ferroelectric materials in the hole 222. The hole 222 may be approximately 30-200 nm in diameter/width, and in some embodiments up to 150 nm. The plate lines 216 may be up to approximately 100-300 nm in thickness, while the insulating material 218 may be up to approximately 50 nm in thickness. In one embodiment, the nodes 220 in each stack 204 may be up to approximately a maximum 2.4 microns in height (300 nm times x 8 plate lines). The node 220 and the channel region are aligned and have the same width, which provides the best area for a memory cell.

In some embodiments, the node 220 may comprise conductive material(s), e.g., metals, such as titanium, titanium nitride, or SrRuO₃ (SRO), as examples.

In some embodiments, one or more of the bitlines 208, the wordlines 210, the plate lines 216 and the via 226 may comprise conductive material(s), e.g., metals, such as titanium, titanium nitride, tantalum nitride, platinum, copper, tungsten, tungsten nitride, and/or ruthenium, among other conductive materials and/or combinations thereof.

In some embodiments, the ferroelectric/antiferroelectric material 224 comprising the ferroelectric capacitor may include, for example, materials exhibiting ferroelectric behavior at thin dimensions, such as hafnium zirconium oxide (HfZrO, also referred to as HZO, which includes hafnium, zirconium, and oxygen), zirconium oxide ZrO, Lanthanum-doped hafnium oxide La-HfO, Lanthanum-doped hafnium zirconium oxide La-HZO, silicon-doped (Si-doped) hafnium oxide (which is a material that includes hafnium, oxygen, and silicon), germanium-doped (Ge-doped) hafnium oxide (which is a material that includes hafnium, oxygen, and germanium), aluminum-doped (Al-doped) hafnium oxide (which is a material that includes hafnium, oxygen, and aluminum), yttrium-doped (Y- doped) hafnium oxide (which is a material that includes hafnium, oxygen, and yttrium), lead zirconate titanate (which is a material that includes lead, zirconium, and titanium), barium zirconate titanate (which is a material that includes barium, zirconium and titanium), and combinations thereof. Some embodiments include hafnium, zirconium, barium, titanium, and/or lead, and combinations thereof. In one embodiment, the ferroelectric material 224 may range from approximately 2 to 50 nm in thickness.

In one embodiment, insulating material 218 comprises interlayer dielectric (ILD) layers. In one embodiment, the insulating material 218 is an oxide layer, e.g., a silicon oxide layer. In one embodiment, insulating material 218 is a low-k dielectric, e.g., silicon dioxide, silicon oxide, carbon doped oxide ("CDO"), or any combination thereof. In one embodiment, the insulating material 218 can include a nitride, oxide, a polymer, phosphosilicate glass, "fluorosilicate ( "SiOF" ( glass, organosilicate glass ( "SiOCH or any combination thereof. In another embodiment, the insulating materials 218 can include a nitride layer, e.g., silicon nitride layer. In alternative embodiments, the insulating materials 218 can include an aluminum oxide, silicon oxide nitride, other oxide/nitride layer, any combination thereof, or other electrically insulating layer determined by an electronic device design.

Each ferroelectric capacitor 202 and plate line 216 combination forms one of the bit cells that are vertically stacked over the access transistor 206. The dimensional requirements of the bit cells are determined primarily by the ferroelectric capacitor 202 or the wordline pitch and bitline pitch. The disclosed embodiment provide a 3D FRAM memory 200 having vertical geometry that provides benefits of 5-1 0× area/bit and cost/bit scaling. In one embodiment, the 3D FRAM memory 200 may have a bit cell area of 4*F*²/*n*, where *n* ≈ 8.

The dummy replacement process will now be described. In general, the process for fabricating a 3D FRAM comprises forming an access transistor at an intersection of a first one of the bitlines and a first one of the wordlines. A series of alternating plate lines and an insulating material substantially parallel to the wordlines are formed over the access transistor. Two or more ferroelectric capacitors are formed over the access transistor and through the series of alternating plate lines and an insulating material such that a first one of the ferroelectric capacitors is coupled to a first one of the plate lines and a second one of the ferroelectric capacitors is coupled to a second one of the plate lines, and wherein the two or more ferroelectric capacitors are each coupled to and controlled by the access transistor. The plate lines are formed using dummy replacement process, which comprises depositing a dummy nitride material in locations of the plate lines between the insulating material. An undercut etch is performed on the dummy nitride that is selective to the insulating material, leaving rows of the insulating material and empty spaces therebetween. An adhesion layer is deposited along a top and bottom surfaces of the rows of the insulating material, and a conformal metal material is deposited between the rows of insulating material to form the plate lines.

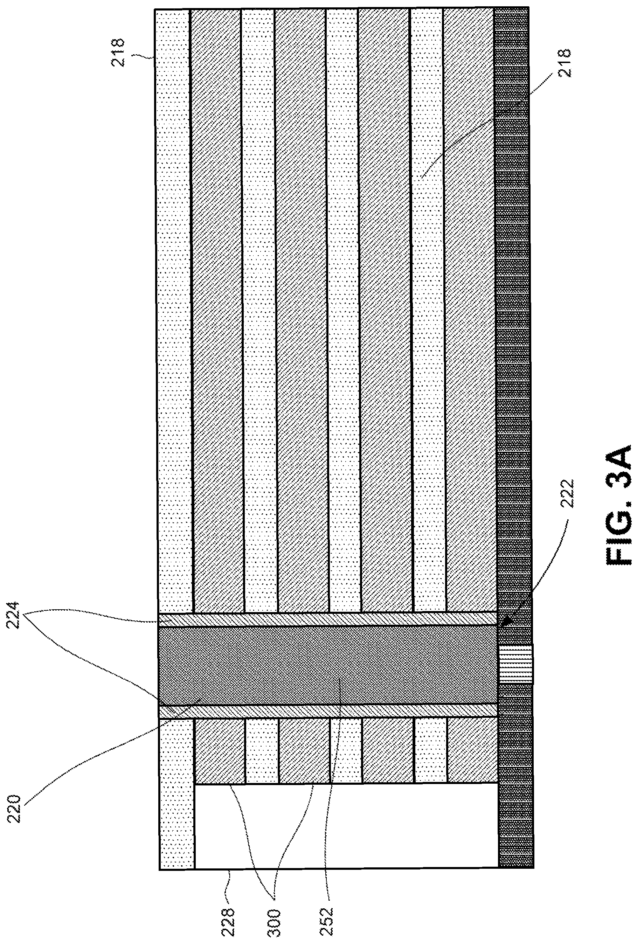

Figures 3A-3F illustrate cross-sectional views showing a process for fabricating a 3D FRAM according to the invention in further detail, where like reference numerals from Figure 2 have like reference numerals. For brevity, Figures 3A-3F illustrate the process after the standard fabrication process of forming an array of FEOL access transistors 206 (not shown) at the base level of the 3D FRAM. This may be done by lithography to form pattern a plurality of substantially parallel bitlines 208 along a first direction within an insulating material over a substrate and forming a plurality of substantially parallel wordlines 210 along a second direction orthogonal to the direction of the bitlines 208, and forming access transistors at the intersections of the bitlines and wordlines.

Figure 3A shows the process after a stack of alternating dummy nitride material 300 and an insulating material 218 are blanket deposited over a substrate and in an isolation region 228, and more specifically over the FEOL transistors in the base level. Depositing the dummy nitride material 300 is in contrast to depositing metal plate lines or doped poly-silicon line from the beginning of the fabrication process. In one embodiment, the dummy nitride material 300 comprises silicon nitride. In alternative embodiments, the dummy nitride material 300 can include an aluminum oxide, silicon oxide nitride, other oxide/nitride layer, any combination thereof, or other electrically insulating layer determined by an electronic device design. In one embodiment, the insulating material 218 may comprise an oxide layer, e.g., a silicon oxide layer. In another embodiment, insulating material 218 is a low-k dielectric, e.g., silicon dioxide, carbon doped oxide ("CDO"), or any combination thereof.

Figure 3A further shows that after the deposition, a node 220 is formed over the access transistor for at least two ferroelectric capacitors, wherein the node 220 is formed through the stack of alternating dummy nitride material 300 and the insulating material 218. In further detail, a lithographic process is performed to etch holes 222 through the stack of alternating dummy nitride material 300 and the insulating material 218 down to a source or drain of the access transistor. A ferroelectric (or antiferroelectric) material 224 is deposited conformal to sidewalls of the holes 222 and spacerized. The remainder of the hole 222 is filled with a metal and planarized to form the node 220.

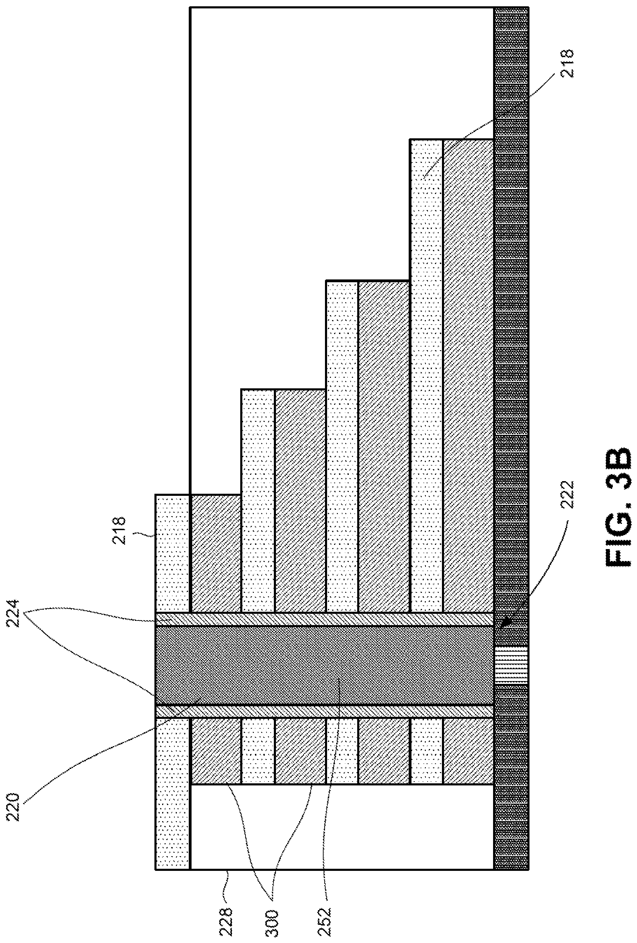

Figure 3B shows the process after a staircase etch is performed on the stack of alternating dummy nitride material 300 and the insulating material 218. The staircase etch begins by depositing a thick hardmask on top of the stack, and a first etch is performed from the top of the stack of the nitride/insulating material insulating layers down to a top of the bottom insulating material 218 to form the first stairstep. An isotropic etch is performed on the hardmask so that the hardmask shrinks on four sides, where one of the sides stops vertically over the position of the next stairstep. A second etch is performed on the stack of the nitride/insulating material insulating layers down to the top of the second to bottom insulating material 218 to form a second stairstep. Another isotropic etch is performed on the hardmask and the process repeats until the top nitride/insulating material insulating layer is etched.

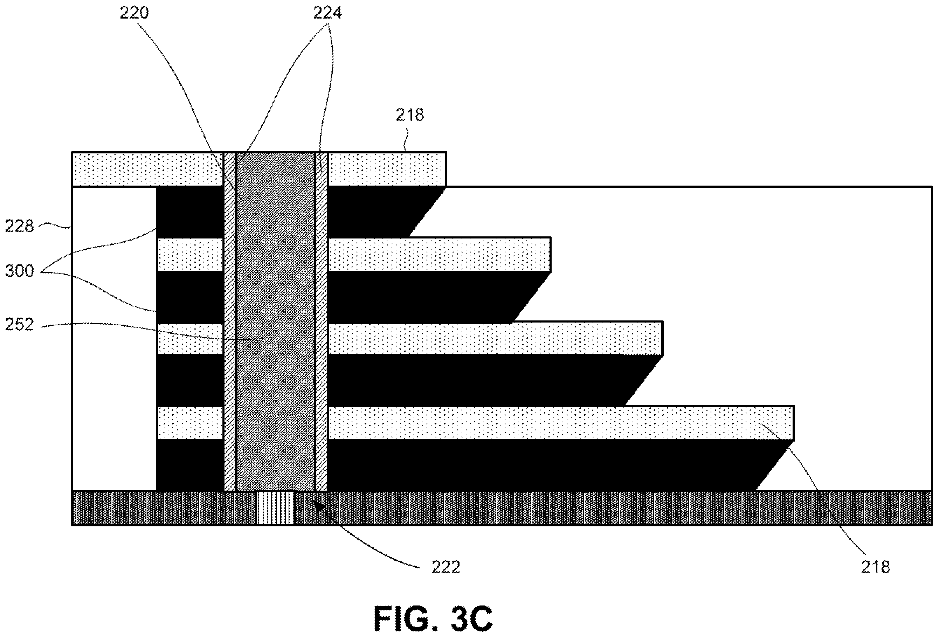

Figure 3C shows the process after the staircase etch, the dummy nitride material 300 is removed during dummy replacement process by performing an undercut etch selective to the insulating material 218. The undercut etch leaves rows the insulating material 218 and empty spaces between rows of the insulating material 218. The rows of the insulating material 218 are attached to and supported by the node 222 and by the isolation region 228 along the sides (shown in black).

Anywhere up to this point, a lithography step may be performed through the stack of the nitride/insulating material insulating layers to see the alignment marks on the first level of the wafer through the stack without having to each through a stack of metal.

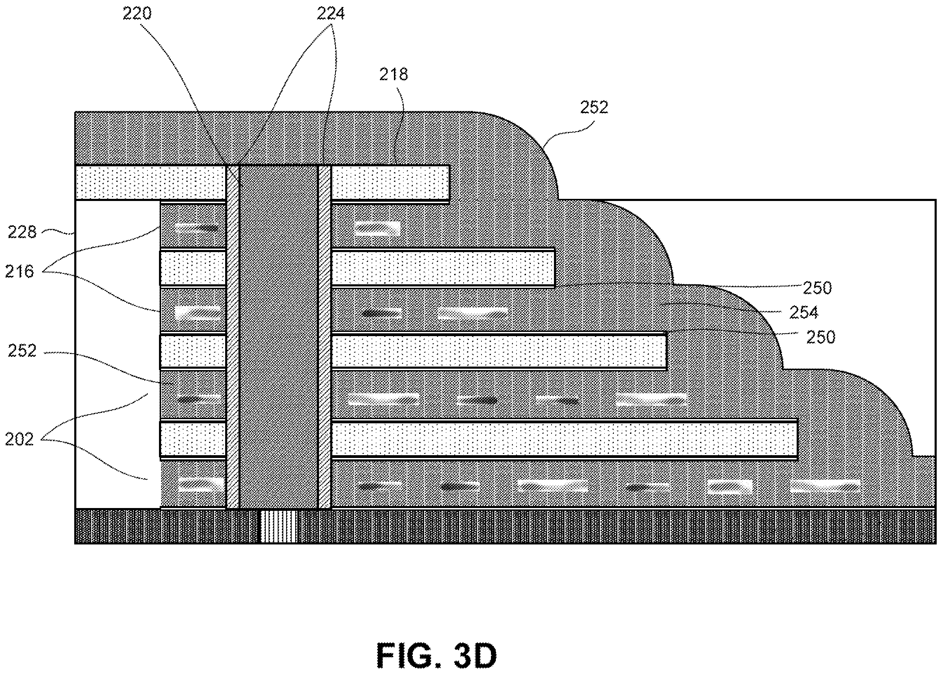

Figure 3D shows the dummy nitride material 300 is replaced by depositing an adhesion layer along 250 top and bottom surfaces of the rows of insulating material 218, and by depositing a conformal metal material 252 on top of the stack and in-between the rows of insulating material 218 to begin formation of plate lines 216. In one embodiment, the metal material 252 is deposited using atomic layer deposition (ALD). Due to the conformal deposition process, voids/keyholes or lines, hereinafter voids 254, may be present in the metal material 252 comprising the plate as a result of the metals touching from top and bottom during the ALD process. In one embodiment, the metal material 252 used as a replacement may be the same or different as a metal material used for the node 220.

In one embodiment, the adhesion layer 250 may comprise titanium nitride and/or tantalum nitride. The metal material 252 may comprise metals, such as titanium, titanium nitride, tantalum nitride, platinum, copper, tungsten, tungsten nitride, molybdenum, and/or ruthenium, among other conductive materials and/or combinations thereof. For instance, in some cases in which a given conductive line comprises Cu, for example, it may be desirable to include between such conductive line and insulating material 218 a barrier and/or adhesion layer comprising a material such as, but not necessarily limited to: tantalum (Ta); tantalum nitride (TaN); titanium nitride (TiN); and the like.

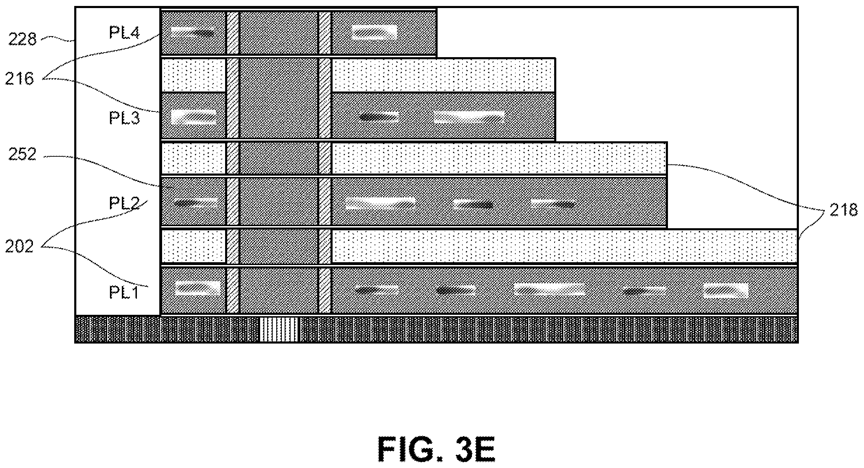

Figure 3E shows the process after anisotropic/vertical etch is performed to directionally remove excess metal material 252 from the top and sidewalls of the insulating material 218 on each of the stair steps so that sidewalls of the plate lines 216 are vertically aligned with sidewalls of the insulating material 218. The anisotropic/vertical etch only etches the metal material 252 and stops on the next layer of insulating material 218 to isolate the plate lines 216.

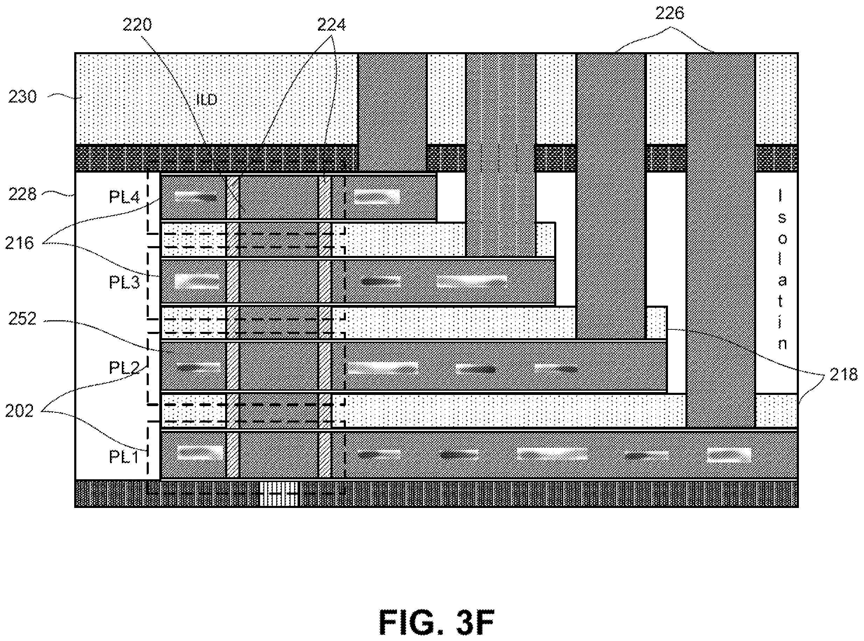

Figure 3F shows the process after another ILD 230 is formed over isolation region 228. A lithographic process is performed on the ILD 230 to define contact and via locations. An etch is performed through the ILD 230 over the contact and via locations that stops on the metal material 252 to form vias 226 through the ILD 230 and isolation region 228 that land on each of the plate lines 216 to form separate capacitors 202 that have a common node 220 at the center.

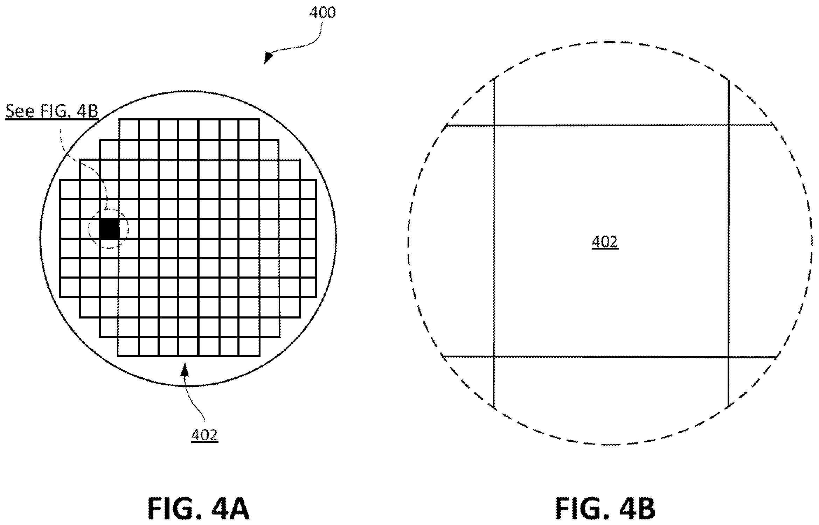

The integrated circuit structures described herein may be included in an electronic device. As an example of one such apparatus, Figures 4A and 4B are top views of a wafer and dies that include one or more ferroelectric trench capacitors, in accordance with one or more of the embodiments disclosed herein.

Referring to Figures 4A and 4B, a wafer 400 may be composed of semiconductor material and may include one or more dies 402 having integrated circuit (IC) structures formed on a surface of the wafer 400. Each of the dies 402 may be a repeating unit of a semiconductor product that includes any suitable IC (e.g., ICs including one or more ferroelectric trench capacitors, such as described above. After the fabrication of the semiconductor product is complete, the wafer 400 may undergo a singulation process in which each of the dies 402 is separated from one another to provide discrete "chips" of the semiconductor product. In particular, structures that include embedded non-volatile memory structures having an independently scaled selector as disclosed herein may take the form of the wafer 400 (e.g., not singulated) or the form of the die 402 (e.g., singulated). The die 402 may include one or more embedded non-volatile memory structures based independently scaled selectors and/or supporting circuitry to route electrical signals, as well as any other IC components. In some embodiments, the wafer 400 or the die 402 may include an additional memory device (e.g., a static random access memory (SRAM) device), a logic device (e.g., an AND, OR, NAND, or NOR gate), or any other suitable circuit element. Multiple ones of these devices may be combined on a single die 402. For example, a memory array formed by multiple memory devices may be formed on a same die 402 as a processing device or other logic that is configured to store information in the memory devices or execute instructions stored in the memory array.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the arts. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured using the approaches disclosed herein.

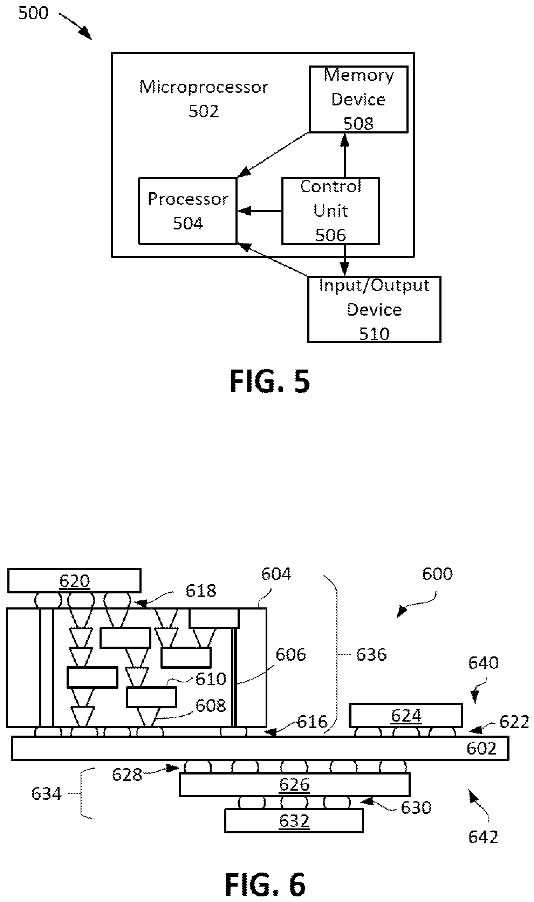

Figure 5 illustrates a block diagram of an electronic system 500, in accordance with an embodiment of the present disclosure. The electronic system 500 can correspond to, for example, a portable system, a computer system, a process control system, or any other system that utilizes a processor and an associated memory. The electronic system 500 may include a microprocessor 502 (having a processor 504 and control unit 506), a memory device 508, and an input/output device 510 (it is to be appreciated that the electronic system 500 may have a plurality of processors, control units, memory device units and/or input/output devices in various embodiments). In one embodiment, the electronic system 500 has a set of instructions that define operations which are to be performed on data by the processor 504, as well as, other transactions between the processor 504, the memory device 508, and the input/output device 510. The control unit 506 coordinates the operations of the processor 504, the memory device 508 and the input/output device 510 by cycling through a set of operations that cause instructions to be retrieved from the memory device 508 and executed. The memory device 508 can include a non-volatile memory cell as described in the present description. In an embodiment, the memory device 508 is embedded in the microprocessor 502, as depicted in Figure 5. In an embodiment, the processor 504, or another component of electronic system 500, includes one or more ferroelectric trench capacitors, such as those described herein.

Figure 6 is a cross-sectional side view of an integrated circuit (IC) device assembly that may include one or more ferroelectric trench capacitors, in accordance with one or more of the embodiments disclosed herein.

Referring to Figure 6, an IC device assembly 600 includes components having one or more integrated circuit structures described herein. The IC device assembly 600 includes a number of components disposed on a circuit board 602 (which may be, e.g., a motherboard). The IC device assembly 600 includes components disposed on a first face 640 of the circuit board 602 and an opposing second face 642 of the circuit board 602. Generally, components may be disposed on one or both faces 640 and 642. In particular, any suitable ones of the components of the IC device assembly 600 may include a number of ferroelectric trench capacitors, such as disclosed herein.

In some embodiments, the circuit board 602 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 602. In other embodiments, the circuit board 602 may be a non-PCB substrate.

The IC device assembly 600 illustrated in Figure 6 includes a package-on-interposer structure 636 coupled to the first face 640 of the circuit board 602 by coupling components 616. The coupling components 616 may electrically and mechanically couple the package-on-interposer structure 636 to the circuit board 602, and may include solder balls (as shown in Figure 6), male and female portions of a socket, an adhesive, an underfill material, and/or any other suitable electrical and/or mechanical coupling structure.

The package-on-interposer structure 636 may include an IC package 620 coupled to an interposer 604 by coupling components 618. The coupling components 618 may take any suitable form for the application, such as the forms discussed above with reference to the coupling components 616. Although a single IC package 620 is shown in Figure 6, multiple IC packages may be coupled to the interposer 604. It is to be appreciated that additional interposers may be coupled to the interposer 604. The interposer 604 may provide an intervening substrate used to bridge the circuit board 602 and the IC package 620. The IC package 620 may be or include, for example, a die (the die 402 of Figure 4B), or any other suitable component. Generally, the interposer 604 may spread a connection to a wider pitch or reroute a connection to a different connection. For example, the interposer 604 may couple the IC package 620 (e.g., a die) to a ball grid array (BGA) of the coupling components 616 for coupling to the circuit board 602. In the embodiment illustrated in Figure 6, the IC package 620 and the circuit board 602 are attached to opposing sides of the interposer 604. In other embodiments, the IC package 620 and the circuit board 602 may be attached to a same side of the interposer 604. In some embodiments, three or more components may be interconnected by way of the interposer 604.

The interposer 604 may be formed of an epoxy resin, a fiberglass-reinforced epoxy resin, a ceramic material, or a polymer material such as polyimide. In some implementations, the interposer 604 may be formed of alternate rigid or flexible materials that may include the same materials described above for use in a semiconductor substrate, such as silicon, germanium, and other group III-V and group IV materials. The interposer 604 may include metal interconnects 610 and vias 608, including but not limited to through-silicon vias (TSVs) 606. The interposer 604 may further include embedded devices, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio-frequency (RF) devices, power amplifiers, power management devices, antennas, arrays, sensors, and microelectromechanical systems (MEMS) devices may also be formed on the interposer 604. The package-on-interposer structure 636 may take the form of any of the package-on-interposer structures known in the art.

The IC device assembly 600 may include an IC package 624 coupled to the first face 640 of the circuit board 602 by coupling components 622. The coupling components 622 may take the form of any of the embodiments discussed above with reference to the coupling components 616, and the IC package 624 may take the form of any of the embodiments discussed above with reference to the IC package 620.

The IC device assembly 600 illustrated in Figure 6 includes a package-on-package structure 634 coupled to the second face 642 of the circuit board 602 by coupling components 628. The package-on-package structure 634 may include an IC package 626 and an IC package 632 coupled together by coupling components 630 such that the IC package 626 is disposed between the circuit board 602 and the IC package 632. The coupling components 628 and 630 may take the form of any of the embodiments of the coupling components 616 discussed above, and the IC packages 626 and 632 may take the form of any of the embodiments of the IC package 620 discussed above. The package-on-package structure 634 may be configured in accordance with any of the package-on-package structures known in the art.

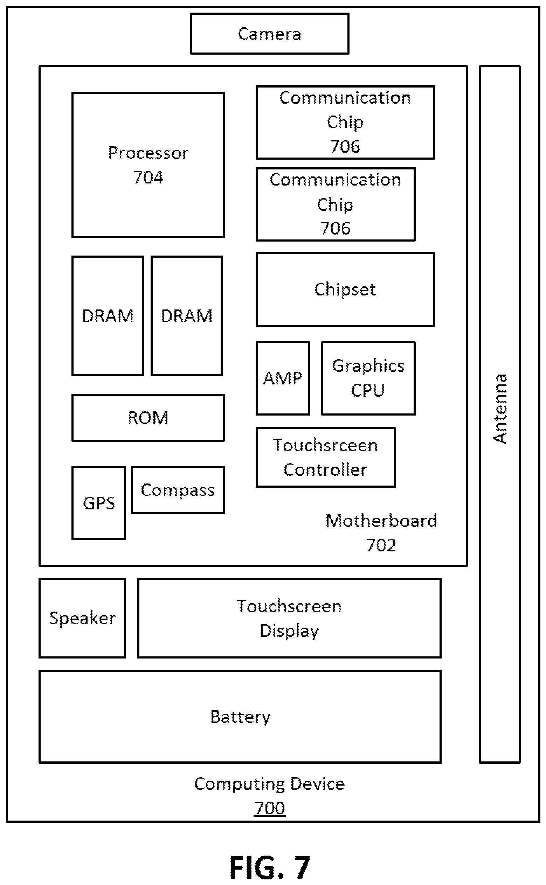

Figure 7 illustrates a computing device 700 in accordance with one implementation of the disclosure. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

Depending on its applications, computing device 700 may include other components that may or may not be physically and electrically coupled to the board 702. These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the disclosure, the integrated circuit die of the processor includes one or more ferroelectric trench capacitors, in accordance with implementations of embodiments of the disclosure. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of embodiments of the disclosure, the integrated circuit die of the communication chip includes one or more ferroelectric trench capacitors, in accordance with implementations of embodiments of the disclosure.

In further implementations, another component housed within the computing device 700 may contain an integrated circuit die that includes one or more ferroelectric trench capacitors, in accordance with implementations of embodiments of the disclosure.

In various implementations, the computing device 700 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 700 may be any other electronic device that processes data.

Thus, embodiments described herein include ferroelectric trench capacitors.

## Claims

1. A memory device (200), comprising:
an access transistor (206) comprising a bitline (208) and a wordline (210);
a series of alternating plate lines (216) and an insulating material (218) over the access transistor (106), the plate lines (216) comprising an adhesion material (250) on a top and a bottom thereof and a metal material (252) in between the adhesion material (250), of the metal material (252) having one or more voids (254) therein;
two or more ferroelectric capacitors (202) over the access transistor (206) and through the series of alternating plate lines (216) and an insulating material (218) such that a first one of the ferroelectric capacitors (202) is coupled to a first one of the plate lines (116) and a second one of the ferroelectric capacitors (202) is coupled to a second one of the plate lines (216), and wherein the two or more ferroelectric capacitors (202) are each coupled to and controlled by the access transistor (206); and
a plurality of vias (226) each via (226) landing on a respective one of the plate lines (216), the plurality of vias (226) comprising a same metal material as the plate lines (216).

2. The memory device (200) of claim 1, wherein the first ferroelectric capacitor (202) and the second ferroelectric capacitor (202) further include: a node (220) located in a hole (222) through a stack (204) of alternating plate lines (216) and an insulating material (218), wherein the node (220) is in alignment with and over the access transistor (206).

3. The memory device of claim 2, wherein a number of the plate lines (216) equals the number of ferroelectric capacitors (202) in the stack (204).

4. The memory device (200) of claim 2 or 3, wherein the number of the ferroelectric capacitors (202) in the stack (204) ranges from 2 to 8.

5. The memory device (200) of claim 2, 3 or 4, wherein the bitline (208) is a source of the access transistor (106), and the node (220) is a drain of the access transistor (206).

6. The memory device (200) of claim 2, 3, 4 or 5, wherein each of the plate lines (216) act as a first electrode and the node (220) acts as a second electrode for the first ferroelectric capacitor (202) and the second ferroelectric capacitor (202).

7. The memory device (200) of claim 2, 3, 4, 5 or 6, further comprising: a ferroelectric material (124) conformal to the sidewalls of the hole (222) and surrounding the node (220).

8. The memory device (200) of claim 7, wherein the ferroelectric material (224) comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

9. The memory device (200) of claim 2, 3, 4, 5,6, 7 or 8, wherein the hole (222) 30-200 nm in diameter.

10. The memory device (200) of claim 2, 3, 4, 5, 6, 7, 8 or 9, wherein the hole (222) is 150 nm in diameter.

11. The memory device (200) of claim 2, 3, 4, 5, 6, 7, 8, 9 or 10, wherein the plate lines (116) are up to 300 nm in thickness, and the insulating material (118) is up to 50 nm in thickness.

12. The memory device (200) of claim 2, 3, 4, 5, 6, 7, 8, 9, 10 or 11, wherein the ferroelectric material (124) is 2 to 50 nm in thickness.

13. A method of fabricating a memory device (200), comprising:
forming an access transistor (206) at an intersection of a first one of bitlines (208) and a first one of wordlines (110),
forming a series of alternating plate lines (216) and an insulating material (218) substantially parallel to the wordlines (210) over the access transistor (206);
forming two or more ferroelectric capacitors (202) over the access transistor (206) and through the series of alternating plate lines (216) and the insulating material (218) such that a first one of the ferroelectric capacitors (202) is coupled to a first one of the plate lines (216) and a second one of the ferroelectric capacitors (202) is coupled to a second one of the plate lines (216), and wherein the two or more ferroelectric capacitors (202) are each coupled to and controlled by the access transistor (206); and
forming the plate lines (216) using a dummy replacement process comprising:
depositing a dummy nitride material (300) in locations of the plate lines (216) between the insulating material (218);
performing an undercut etch on the dummy nitride material (300) that is selective to the insulating material (218), leaving rows of the insulating material (218) and empty spaces therebetween;
depositing an adhesion layer (250) along top and bottom surfaces of the rows of the insulating material (218) and depositing a conformal metal material (252) between the rows of insulating material (218) to form the plate lines (216).

14. The method of claim 13, wherein the two or more ferroelectric capacitors (202) are formed in a hole (222) through the series of alternating plate lines (216) and an insulating material (218), and wherein the hole (222) is lined with a ferroelectric or antiferroelectric material (224) and filled with a conductive material to form a node (220).

15. The method of claim 13 or 14, wherein the ferroelectric material (224) comprises any combination of one or more of: hafnium, zirconium, and oxygen; hafnium, oxygen, and silicon; hafnium, oxygen, and germanium; hafnium, oxygen, and aluminum; hafnium, oxygen, and yttrium; hafnium, oxygen, and lanthanum; lead, zirconium, and titanium; barium, zirconium and titanium; hafnium, zirconium, barium, and titanium; and hafnium, zirconium, barium, and lead.

## Patentansprüche

1. Speichervorrichtung (200), die Folgendes umfasst:
einen Zugriffstransistor (206), der eine Bitleitung (208) und eine Wortleitung (210) umfasst;
eine Reihe aus abwechselnd Plattenleitungen (216) und einem Isoliermaterial (218) über dem Zugriffstransistor (106), wobei die Plattenleitungen (216) ein Haftmaterial (250) auf einer Oberseite und einer Unterseite davon und ein Metallmaterial (252) zwischen dem Haftmaterial (250) umfassen, wobei das Metallmaterial (252) einen oder mehrere Hohlräume (254) darin aufweist;
zwei oder mehr ferroelektrische Kondensatoren (202) über dem Zugriffstransistor (206) und durch die Reihe aus abwechselnd Plattenleitungen (216) und einem Isoliermaterial (218), sodass ein erster der ferroelektrischen Kondensatoren (202) mit einer ersten der Plattenleitungen (116) gekoppelt ist und ein zweiter der ferroelektrischen Kondensatoren (202) mit einer zweiten der Plattenleitungen (216) gekoppelt ist, und wobei die zwei oder mehr ferroelektrischen Kondensatoren (202) jeweils mit dem Zugriffstransistor (206) gekoppelt sind und durch diesen gesteuert werden; und
eine Mehrzahl von Vias (226), wobei jede Via (226) auf einer jeweiligen der Plattenleitungen (216) landet, wobei die Mehrzahl von Vias (226) ein gleiches Metallmaterial wie die Plattenleitungen (216) umfasst.

2. Speichervorrichtung (200) nach Anspruch 1, wobei der erste ferroelektrische Kondensator (202) und der zweite ferroelektrische Kondensator (202) ferner aufweisen: einen Knoten (220), der sich in einem Loch (222) durch einen Stapel (204) aus abwechselnd Plattenleitungen (216) und einem Isoliermaterial (218) befindet, wobei der Knoten (220) mit und über dem Zugriffstransistor (206) ausgerichtet ist.

3. Speichervorrichtung nach Anspruch 2, wobei eine Anzahl der Plattenleitungen (216) gleich der Anzahl ferroelektrischer Kondensatoren (202) im Stapel (204) ist.

4. Speichervorrichtung (200) nach Anspruch 2 oder 3, wobei die Anzahl der ferroelektrischen Kondensatoren (202) im Stapel (204) in einem Bereich von 2 bis 8 liegt.

5. Speichervorrichtung (200) nach Anspruch 2, 3 oder 4, wobei die Bitleitung (208) eine Source des Zugriffstransistors (106) ist und der Knoten (220) ein Drain des Zugriffstransistors (206) ist.

6. Speichervorrichtung (200) nach Anspruch 2, 3, 4 oder 5, wobei jede der Plattenleitungen (216) als eine erste Elektrode agiert und der Knoten (220) als eine zweite Elektrode für den ersten ferroelektrischen Kondensator (202) und den zweiten ferroelektrischen Kondensator (202) agiert.

7. Speichervorrichtung (200) nach Anspruch 2, 3, 4, 5 oder 6, ferner umfassend: ein ferroelektrisches Material (124) konform zu den Seitenwänden des Lochs (222) und den Knoten (220) umgebend.

8. Speichervorrichtung (200) nach Anspruch 7, wobei das ferroelektrische Material (224) eine beliebige Kombination aus einem oder mehreren des Folgenden umfasst: Hafnium, Zirkonium und Sauerstoff; Hafnium, Sauerstoff und Silizium; Hafnium, Sauerstoff und Germanium; Hafnium, Sauerstoff und Aluminium; Hafnium, Sauerstoff und Yttrium; Hafnium, Sauerstoff und Lanthan; Blei, Zirkonium und Titan; Barium, Zirkonium und Titan; Hafnium, Zirkonium, Barium und Titan; und Hafnium, Zirkonium, Barium und Blei.

9. Speichervorrichtung (200) nach Anspruch 2, 3, 4, 5, 6, 7 oder 8, wobei das Loch (222) einen Durchmesser von 30-200 nm aufweist.

10. Speichervorrichtung (200) nach Anspruch 2, 3, 4, 5, 6, 7, 8 oder 9, wobei das Loch (222) einen Durchmesser von 150 nm aufweist.

11. Speichervorrichtung (200) nach Anspruch 2, 3, 4, 5, 6, 7, 8, 9 oder 10, wobei die Plattenleitungen (116) eine Dicke von bis zu 300 nm aufweisen und das Isoliermaterial (118) eine Dicke von bis zu 50 nm aufweist.

12. Speichervorrichtung (200) nach Anspruch 2, 3, 4, 5, 6, 7, 8, 9, 10 oder 11, wobei das ferroelektrische Material (124) eine Dicke von 2 bis 50 nm aufweist.

13. Verfahren zur Herstellung einer Speichervorrichtung (200), das Folgendes umfasst:
Bilden eines Zugriffstransistors (206) an einem Schnittpunkt einer ersten von Bitleitungen (208) und einer ersten von Wortleitungen (110),
Bilden einer Reihe aus abwechselnd Plattenleitungen (216) und einem Isoliermaterial (218) im Wesentlichen parallel zu den Wortleitungen (210) über dem Zugriffstransistor (206);
Bilden von zwei oder mehr ferroelektrischen Kondensatoren (202) über dem Zugriffstransistor (206) und durch die Reihe aus abwechselnd Plattenleitungen (216) und dem Isoliermaterial (218), sodass ein erster der ferroelektrischen Kondensatoren (202) mit einer ersten der Plattenleitungen (216) gekoppelt ist und ein zweiter der ferroelektrischen Kondensatoren (202) mit einer zweiten der Plattenleitungen (216) gekoppelt ist, und
wobei die zwei oder mehr ferroelektrischen Kondensatoren (202) jeweils mit dem Zugriffstransistor (206) gekoppelt sind und durch diesen gesteuert werden; und
Bilden der Plattenleitungen (216) unter Verwendung eines Dummy-Austauschprozesses, der umfasst:
Abscheiden eines Dummy-Nitridmaterials (300) an Orten der Plattenleitungen (216) zwischen dem Isoliermaterial (218);
Durchführen einer Unterschnittätzung auf dem Dummy-Nitridmaterial (300), die selektiv für das Isoliermaterial (218) ist, wodurch Zeilen des Isoliermaterials (218) und Leerräume dazwischen verbleiben;
Abscheiden einer Haftschicht (250) entlang oberer und unterer Oberflächen der Zeilen des Isoliermaterials (218) und Abscheiden eines konformen Metallmaterials (252) zwischen den Zeilen von Isoliermaterial (218), um die Plattenleitungen (216) zu bilden.

14. Verfahren nach Anspruch 13, wobei die zwei oder mehr ferroelektrischen Kondensatoren (202) in einem Loch (222) durch die Reihe aus abwechselnd Plattenleitungen (216) und einem Isoliermaterial (218) gebildet werden, und wobei das Loch (222) mit einem ferroelektrischen oder antiferroelektrischen Material (224) ausgekleidet und mit einem leitfähigen Material gefüllt ist, um einen Knoten (220) zu bilden.

15. Verfahren nach Anspruch 13 oder 14, wobei das ferroelektrische Material (224) eine beliebige Kombination aus einem oder mehreren des Folgenden umfasst: Hafnium, Zirkonium und Sauerstoff; Hafnium, Sauerstoff und Silizium; Hafnium, Sauerstoff und Germanium; Hafnium, Sauerstoff und Aluminium; Hafnium, Sauerstoff und Yttrium; Hafnium, Sauerstoff und Lanthan; Blei, Zirkonium und Titan; Barium, Zirkonium und Titan; Hafnium, Zirkonium, Barium und Titan; und Hafnium, Zirkonium, Barium und Blei.

## Revendications

1. Dispositif (200) de mémoire, comportant :
un transistor (206) d'accès comportant une ligne (208) de bits et une ligne (210) de mots ;
une série de lignes (216) de plaque alternées et d'un matériau isolant (218) par-dessus le transistor (106) d'accès, les lignes (216) de plaque comportant un matériau (250) d'adhérence sur un dessus et un dessous de celles-ci et un matériau métallique (252) entre le matériau (250) d'adhérence, le matériau métallique (252) présentant un ou plusieurs vides (254) dans celui-ci ;
au moins deux condensateurs ferroélectriques (202) par-dessus le transistor (206) d'accès et à travers la série de lignes (216) de plaque alternées et d'un matériau isolant (218) de telle façon qu'un premier des condensateurs ferroélectriques (202) soit couplé à une première des lignes (116) de plaque et qu'un second des condensateurs ferroélectriques (202) soit couplé à une seconde des lignes (216) de plaque, et chacun desdits au moins deux condensateurs ferroélectriques (202) étant couplé au transistor (206) d'accès et commandé par celui-ci ; et
une pluralité de traversées (226), chaque traversée (226) aboutissant sur une ligne respective parmi les lignes (216) de plaque, la pluralité de traversées (226) comportant un même matériau métallique que les lignes (216) de plaque.

2. Dispositif (200) de mémoire selon la revendication 1, le premier condensateur ferroélectrique (202) et le second condensateur ferroélectrique (202) comprenant en outre: un nœud (220) situé dans un trou (222) à travers un empilement (204) de lignes (216) de plaque alternées et d'un matériau isolant (218), le nœud (220) se trouvant en alignement avec et par-dessus le transistor (206) d'accès.

3. Dispositif de mémoire selon la revendication 2, un nombre des lignes (216) de plaque égalant le nombre de condensateurs ferroélectriques (202) dans l'empilement (204).

4. Dispositif (200) de mémoire selon les revendications 2 ou 3, le nombre des condensateurs ferroélectriques (202) dans l'empilement (204) allant de 2 à 8.

5. Dispositif (200) de mémoire selon les revendications 2, 3 ou 4, la ligne (208) de bits étant une source du transistor (106) d'accès, et le nœud (220) étant un drain du transistor (206) d'accès.

6. Dispositif (200) de mémoire selon les revendications 2, 3, 4 ou 5, chacune des lignes (216) de plaque agissant comme une première électrode et le nœud (220) agissant comme une seconde électrode pour le premier condensateur ferroélectrique (202) et le second condensateur ferroélectrique (202).

7. Dispositif (200) de mémoire selon les revendications 2, 3, 4, 5 ou 6, comportant en outre: un matériau ferroélectrique (124) épousant les parois latérales du trou (222) et entourant le nœud (220).

8. Dispositif (200) de mémoire selon la revendication 7, le matériau ferroélectrique (224) comportant une combinaison quelconque d'un ou de plusieurs constituants parmi : hafnium, zirconium et oxygène ; hafnium, oxygène et silicium; hafnium, oxygène et germanium ; hafnium, oxygène et aluminium ; hafnium, oxygène et yttrium ; hafnium, oxygène et lanthane ; plomb, zirconium et titane ; baryum, zirconium et titane ; hafnium, zirconium, baryum et titane ; et hafnium, zirconium, baryum et plomb.

9. Dispositif (200) de mémoire selon les revendications 2, 3, 4, 5,6, 7 ou 8, le trou (222) présentant un diamètre de 30 à 200 nm.

10. Dispositif (200) de mémoire selon les revendications 2, 3, 4, 5, 6, 7, 8 ou 9, le trou (222) présentant un diamètre de 150 nm.

11. Dispositif (200) de mémoire selon les revendications 2, 3, 4, 5, 6, 7, 8, 9 ou 10, les lignes (116) de plaque présentant une épaisseur pouvant aller jusqu'à 300 nm, et le matériau isolant (118) présentant une épaisseur pouvant aller jusqu'à 50 nm.

12. Dispositif (200) de mémoire selon les revendications 2, 3, 4, 5, 6, 7, 8, 9, 10 ou 11, le matériau ferroélectrique (124) présentant une épaisseur de 2 à 50 nm.

13. Procédé de fabrication d'un dispositif (200) de mémoire, comportant :
la formation d'un transistor (206) d'accès à une intersection d'une première ligne parmi des lignes (208) de bits et d'une première ligne parmi des lignes (110) de mots,
la formation d'une série de lignes (216) de plaque alternées et d'un matériau isolant (218) sensiblement parallèle aux lignes (210) de mots par-dessus le transistor (206) d'accès ;
la formation d'au moins deux condensateurs ferroélectriques (202) par-dessus le transistor (206) d'accès et à travers la série de lignes (216) de plaque alternées et le matériau isolant (218) de telle façon qu'un premier des condensateurs ferroélectriques (202) soit couplé à une première des lignes (216) de plaque et qu'un second des condensateurs ferroélectriques (202) soit couplé à une seconde des lignes (216) de plaque, et chacun desdits au moins deux condensateurs ferroélectriques (202) étant couplé au transistor (206) d'accès et commandé par celui-ci ; et
la formation des lignes (216) de plaque à l'aide d'un processus de remplacement de matière inerte comportant :
le dépôt d'un matériau (300) de nitrure inerte aux emplacements des lignes (216) de plaque entre le matériau isolant (218) ;
la réalisation d'une gravure sous-jacente sur le matériau (300) de nitrure inerte qui est sélective vis-à-vis du matériau isolant (218), laissant des rangées du matériau isolant (218) et des espaces vides entre celles-ci ;
le dépôt d'une couche (250) d'adhérence le long de surfaces supérieure et inférieure des rangées du matériau isolant (218) et le dépôt d'un matériau métallique conforme (252) entre les rangées de matériau isolant (218) pour former les lignes (216) de plaque.

14. Procédé selon la revendication 13, lesdits au moins deux condensateurs ferroélectriques (202) étant formés dans un trou (222) à travers la série de lignes (216) de plaque alternées et d'un matériau isolant (218), et le trou (222) étant revêtu d'un matériau ferroélectrique ou anti-ferroélectrique (224) et rempli d'un matériau conducteur pour former un nœud (220).

15. Procédé selon les revendications 13 ou 14, le matériau ferroélectrique (224) comportant une combinaison quelconque d'un ou de plusieurs constituants parmi : hafnium, zirconium et oxygène ; hafnium, oxygène et silicium ; hafnium, oxygène et germanium ; hafnium, oxygène et aluminium; hafnium, oxygène et yttrium ; hafnium, oxygène et lanthane ; plomb, zirconium et titane ; baryum, zirconium et titane ; hafnium, zirconium, baryum et titane ; et hafnium, zirconium, baryum et plomb.
